Europäisches Patentamt

**European Patent Office**

**Office européen des brevets**

(19)

(11) Veröffentlichungsnummer: **0 216 212**
**A2**

(12) # EUROPÄISCHE PATENTANMELDUNG

(21) Anmeldenummer: **86112162.2**

(22) Anmeldetag: **02.09.86**

(51) Int. Cl.⁴: **H 01 S 3/08**

(30) Priorität: **25.09.85 DE 3534190**
**13.01.86 DE 3600726**

(43) Veröffentlichungstag der Anmeldung:
**01.04.87 Patentblatt 87/14**

(84) Benannte Vertragsstaaten:
**AT BE CH DE FR GB IT LI LU NL SE**

(71) Anmelder: **Siemens Aktiengesellschaft Berlin und München**
**Wittelsbacherplatz 2**
**D-8000 München 2(DE)**

(72) Erfinder: **Böck, Georg, Dr.**
**Donarweg 3**
**D-8000 München 83(DE)**

(54) **Externer optischer Resonator für einen Halbleiterlaser.**

(57) Es wird ein externer optischer Resonator für einen Halbleiterlaser (HL) beschrieben. Bei einem solchen Resonator soll eine hohe Selektivität und Phasensteilheit des Eingangsreflexionsfaktors in der Umgebung der Resonanz und die damit verbundene hohe Güte bei hoher Stabilität erreicht werden. Dies wird mit einem an den Halbleiterlaser (HL) ankoppelbaren optischen Richtkoppler (RK) erreicht, bei dem zwei Tore (2, 4) durch eine Strahlungsübertragungsstrecke (EU) zum kopplerexternen Übertragen von Strahlungsleistung zwischen diesen Toren miteinander verbunden sind, in der eine Rückkopplungseinrichtung (RE) zum Rückkoppeln eines Anteils der aus dem Richtkoppler (RK) auf die Übertragungsstrecke (EU) ausgekoppelten Strahlungsleistung zurück in den Richtkoppler angeordnet ist. Der Koppelfaktor des Richtkopplers ist so gewählt, daß die in einen Wellenleiter des Kopplers (RK) eingekoppelte Strahlung nahezu vollständig auf dessen anderen Wellenleiter überkoppelt. Durch Verwendung eines wellenlängenselektiven Richtkopplers anstelle eines breitbandigen kann eine nahezu vollständige Unterdrückung aller Nebenmoden erhalten werden.

FIG 1

EP 0 216 212 A2

Siemens Aktiengesellschaft
Berlin und München

Unser Zeichen
86 P 1 0 0 6 E

## Externer optischer Resonator für einen Halbleiterlaser

Die vorliegende Erfindung betrifft gemäß dem Oberbegriff des Patentanspruchs 1 einen externen optischen Resonator für einen Halbleiterlaser.

Für die Realisierung kohärent optischer Übertragungssysteme werden einmodige Halbleiterlasersender extrem geringer Linienbreite benötigt. Da gegenwärtig erhältliche Laserdioden derart schmale Linienbreiten nicht aufweisen, sind im allgemeinen zusätzliche externe Maßnahmen notwendig, um die gewünschten spektralen Eigenschaften zu erzielen. Eine mittlerweile mehrfach publizierte und angewandte Methode zur Linienverschmälerung ist die Ankopplung an einen externen Resonator bei freier Strahlausbreitung (siehe dazu R. Wyatt, W.J. Devlin: 10 kHz Linewidth 1,5 µm InGaAsP External Cavitiy Laser with 55 nm Tuning Range, Electr. Lett. 19 (1983) S. 110-112 ). Der dort beschriebene Aufbau weist jedoch eine unzureichende Stabilität auf und ist mit erheblichem Aufwand verbunden. Ferner besteht aufgrund der periodischen Resonanzstruktur des dort verwendeten Fabry-Perrot-Resonators die Gefahr des sog. Modenhüpfens.

Die Gefahr des Modenhüpfens besteht auch bei einem entsprechenden Aufbau in Fasertechnik, der in F. Favre, D. Le Guen: Emission Frequency Stability in Single-Mode-Fibre Optical Feedback Controlled Semiconductors Lasers, Electr. Lett. 19 (1983) S. 663-665, beschrieben ist, und bei dem ferner die zusätzliche Frequenzselektivität fehlt.

Ed 1 Sti/16.12.1985

Aufgabe der vorliegenden Erfindung ist es, einen Resonator der eingangs genannten Art anzugeben, der eine hohe Selektivität und Phasensteilheit des Eingangsreflexionsfaktors in der Umgebung der Resonanz und die damit verbundene hohe Güte aufweist.

Diese Aufgabe wird gemäß dem kennzeichnenden Teil des Patentanspruchs 1 gelöst durch einen optischen Viertor-Koppler, wobei durch ein an den Halbleiterlaser ankoppelbares erstes Tor des Kopplers eingekoppelte Strahlungsleistung aus dem vom Halbleiterlaser abgestrahlten Spektralbereich nur geringfügig auf ein zweites Tor des Kopplers und nahezu vollständig auf ein drittes Tor überkoppelt, wobei durch ein viertes Tor des Kopplers eingekoppelte Strahlungsleistung aus dem genannten Spektralbereich nahezu vollständig auf das zweite Tor und nur geringfügig auf das dritte Tor überkoppelt, und wobei durch das zweite Tor eingekoppelte Strahlungsleistung aus dem genannten Spektralbereich auf das erste Tor überkoppelt, durch eine zwischen das zweite Tor und das vierte Tor geschaltete und einen optischen Wellenleiter aufweisende Strahlungsübertragungsstrecke zur kopplerexternen Übertragung von Strahlungsleistung zwischen dem zweiten und vierten Tor des Kopplers und durch eine Rückkopplungseinrichtung zum Rückkoppeln eines bestimmten Anteils der aus dem zweiten Tor ausgekoppelten und auf der Strahlungsübertragungsstrecke übertragenen Strahlungsleistung zurück in dieses zweite Tor.

Mit dem erfindungsgemäßen Resonator lassen sich schmale Selektionskurven erzielen, die nach bisherigen Publikationen (siehe L.F. Stokes, M. Chodorow, H.J. Show: Allsingle-mode fibre resonator, Optics Lett. 7 (1982) S. 288-290 und E.J. Bachus, R.P. Braun, B. Strebel: Polarisation-maintaining single mode fibre resonator, Electr. Lett. 19 (1983) S. 1027-1028) jeweils nur für

den Transmissionsfaktor erzielt wurden. Derartige Anordnungen sind als externe optische Resonatoren für Halbleiterlaser jedoch unbrauchbar.

Geringfügige und nahezu vollständige Überkopplung von einem Tor auf ein anderes bedeutet prinzipiell, daß weniger bzw. mehr als 50% der eingekoppelten Strahlungsleistung überkoppeln, wobei es um so günstiger ist, je weiter die beiden Grade der Überkopplung von 50 % entfernt sind. Bevorzugterweise koppelt gemäß Anspruch 2 der Koppler zwischen 95 % und 100 % der durch das erste Tor eingekoppelten Strahlungsleistung aus dem genannten Spektralbereich auf das dritte Tor über. Des weiteren ist der Koppler bevorzugterweise nach Anspruch 3 so ausgebildet, daß er zwischen 95 % und 100 % der durch das vierte Tor eingekoppelten Strahlungsleistung auf das zweite Tor überkoppelt.

Ein erfindungsgemäßer Resonator kann gemäß Anspruch 3 so ausgebildet sein, daß der Viertor-Koppler ein breitbandiger Koppler ist. Dies bedeutet, daß sein oben definiertes Koppelverhalten für einen breiten Wellenlängenbereich gilt.

Vorteilhafterweise besteht jedoch gemäß Anspruch 4 der Viertor-Koppler aus einem wellenlängenselektiven Koppler. Dies bedeutet, daß das angegebene Koppelverhalten nur in dem vom Halbleiterlaser abgestrahlten Spektralbereich oder einem in diesen Bereich fallenden engeren Spektralbereich besteht und vorzugsweise außerhalb dieses Bereichs keine nennenswerte Überkopplung auftritt. Mit einem solchen Resonator gelingt eine nahezu vollständige Unterdrückung aller Nebenmoden. Dabei sollte die Kopplerbandbreite etwa gleich dem freien Spektralbereich des Resonators sein, d.h. dem Abstand zwischen dem zentralen Mode und einem Nachbarmode. Allerdings wird auch bei der dreifachen Kopplerbandbreite noch eine relativ starke Unterdrückung der Nachbar- oder Nebenmoden erhalten.
Auch in diesem Fall bleibt die Selektivität des einzelnen Modes unverändert.

Bei einer bevorzugten Ausgestaltung des erfindungsgemäßen Resonators koppelt gemäß Anspruch 6 auf das dritte Tor überkoppelnde Strahlungsleistung rückwirkungsfrei aus diesem Tor aus. Besonders vorteilhaft ist es, einen an den Halbleiterlaser anzukoppelnden optischen Wellenleiter nicht wie bisher üblich auf der von dem Resonator abgekehrten Seite des Halbleiterlasers anzukoppeln, sondern ihn vielmehr gemäß Anspruch 7 über das dritte Tor des Richtkopplers an den Halbleiterlaser anzukoppeln, also auf der Resonatorseite. Dadurch lassen sich erhebliche Justierprobleme beseitigen, weil nur noch der Koppler und der Halbleiterlaser aufeinandereinzujustieren sind. Die Kopplung des besagten Wellenleiters an das dritte Tor des Kopplers ist problemlos. Beispielsweise können ein optischer Wellenleiter des Kopplers und der an den Halbleiterlaser anzukoppelnde Wellenleiter aus einem Stück gebildet sein.

Wenn der an den Halbleiterlaser anzukoppelnde Wellenleiter jedoch auf der vom Resonator abgekehrten Seite des Halbleiterlaser angekoppelt wird, ist es für eine rückwirkungsfreie Auskopplung der Strahlungsleistung aus dem dritten Tor des Kopplers zweckmäßig, nach Anspruch 8 die rückwirkungsfreie Auskopplung aus dem dritten Tor durch einen Strahlungsabsorber zu bewirken, der die ausgekoppelte Strahlungsleistung absorbiert.

Vorteilhafterweise besteht der wellenlängenselektive oder auch breitbandige Koppler gemäß Anspruch 9 aus einem optischen Richtkoppler. Dieser kann gemäß Anspruch 10 aus einem Glasfaser-Richtkoppler bestehen, gemäß Anspruch 11 aber auch ein integrierter Koppler sein.

Der optische Wellenleiter der Strahlungsübertragungsstrecke kann nach Anspruch 12 aus einer Glasfaser bestehen. Dies ist insbesondere im Fall des Resonators
nach Anspruch 10 zweckmäßig. Der optische Wellenleiter
kann aber gemäß Anspruch 13 auch aus einem integrierten
Wellenleiter bestehen, der insbesondere im Fall des
Resonators nach Anspruch 11 zweckmäßig ist und einen
kompakten raumsparenden Aufbau des Resonators ermöglicht.

Im Fall des Resonators nach Anspruch 13 ist der integrierte Wellenleiter zweckmäßigerweise gemäß Anspruch 14
ein in einem Glaskörper durch ein Ionenaustauschverfahren ausgebildeter Wellenleiter.

Ein besonders wichtiges Merkmal des erfindungsgemäßen
Resonators ist die Rückkopplungseinrichtung, genauer der
von dieser Rückkopplungseinrichtung in das zweite Tor
zurückgekoppelte Anteil der aus diesem Tor ausgekoppelten und auf der Strahlungsübertragungsstrecke übertragenen Strahlungsleistung, denn dieser beeinflußt stark
das Verhalten des Resonators. Durch Variation dieses
Anteils können Kurvenformen des Eingangsreflexionsfaktors
von stark unterkritisch bis stark überkritisch realisiert
werden.

Konstruktiv läßt sich die Rückkopplungseinrichtung sehr
leicht realisieren, wenn sie gemäß Anspruch 15 aus einem
teildurchlässigen Reflektor besteht. In diesem Fall bestimmt sich der in das zweite Tor zurückgekoppelte Anteil der aus diesem Tor ausgekoppelten Strahlungsleistung durch den Reflexionsfaktor r dieses Reflektors.

Besonders einfach läßt sich der teildurchlässige Reflektor gemäß Anspruch 16 durch einen Brechzahlsprung realisieren, bei dem sich der Reflexionsfaktor r durch die
bekannte Beziehung $r = (n_1-n_2)^2/(n_1+n_2)^2$ gegeben ist,

wobei $n_1$ und $n_2$ die effektiven Brechzahlen der beiden aneinandergrenzenden und den Sprung definierenden Medien bedeuten.

Der Brechzahlsprung kann nach Anspruch 17 durch ein einige zehn bis einhundert Wellenlängen dickes Glasplättchen realisiert sein, das in der Strahlungsübertragungsstrecke angeordnet ist oder gemäß Anspruch 18 einfach durch eine Immersionsflüssigkeit. Er kann auch zweckmäßigerweise nach Anspruch 19 durch eine Endflächenkopplung zweier optischer Wellenleiter unterschiedlicher Brechzahl realisiert sein.

Der teildurchlässige Reflektor kann aber gemäß Anspruch 20 auch durch aufgedampfte Schichten realisiert sein.

Eine im Hinblick auf die Unterdrückung von Nachbarmoden zum zentralen Mode in der Umgebung der Resonanz besonders vorteilhafte Ausbildung eines erfindungsgemäßen Resonators ist nach Anspruch 21 durch eine frequenzselektiv wirkende Rückkopplungseinrichtung gekennzeichnet, die gemäß Anspruch 22 durch eine auf einem optischen Wellenleiter ausgebildete Beugungsgitterstruktur gebildet sein kann. Eine derartige Struktur ist beispielsweise aus W. V. Sorin, H.J. Schaw: A Single-Mode Fiber Evanescent Grating Reflector, J. of Lightwave Technology, Vol. LT-3, No. 5, Oct. 1985, bekannt und kann bei dem erfindungsgemäßen Resonator als Rückkopplungseinrichtung verwendet werden.

Bei einer bevorzugten Ausgestaltung des erfindungsgemäßen Resonators ist gemäß Anspruch 23 die Rückkopplungseinrichtung zwischen dem zweiten oder dem vierten Tor des Viertor-Kopplers und dem daran angekoppelten optischen Wellenleiter angeordnet.

Bei einer vorteilhaften Ausgestaltung des erfindungsgemäßen Resonators sind gemäß Anspruch 24 zwei oder
mehrere Rückkopplungseinrichtungen in der Strahlungsübertragungsstrecke angeordnet. Dadurch lassen sich Nachbarmoden teilweise unterdrücken, wobei die Selektivität des
einzelnen Modes nicht beeinflußt wird.

Bei einem derartigen Resonator ist es zweckmäßig, wenn
gemäß Anspruch 25 eine Rückkopplungseinrichtung mit Abstand von dem zweiten und vierten Tor des Kopplers angeordnet ist. Eine spezielle Ausgestaltung dieses Resonators ist so ausgebildet, daß gemäß Anspruch 26 die mit
Abstand von dem zweiten und vierten Tor angeordnete
Rückkopplungseinrichtung im Abstand von drei Vierteln
der gesamten Länge der Strahlungsübertragungsstrecke von
dem zweiten Tor angeordnet ist, wo sich auch die eine
Rückkopplungseinrichtung befindet.

Ein besonderer Vorzug des erfindungsgemäßen Resonators
gegenüber herkömmlichen Resonatoren ohne Strahlungsübertragungsstrecke ist darin zu sehen, daß der freie Spektralbereich bei gleichen Resonatorlängen verdoppelt ist.
Auch tritt bei Verwendung des wellenlängenselektiven Richtkopplers und/oder einer wellenlängenselektiven Rückkopplungseinrichtung das bei bekannten Resonatoren vorhandene Problem der periodischen Reflektivität nicht auf.

Die Erfindung wird anhand der Figuren in der folgenden
Beschreibung näher erläutert. Von den Figuren zeigen:

Figur 1 den schematischen Aufbau eines Resonators mit
        Strahlungsübertragungsstrecke,

Figur 2 eine ebenfalls schematisch dargestellte Modifikation des Resonators nach Figur 1,

Figur 3 die Wellenlängenabhängigkeit des Betrags des
        Eingangsreflexionsfaktors $S_{11}$ eines herkömmli-
        chen Resonators von 0,9 m Länge in der Umgebung der Resonanz für verschiedene Reflexionsfaktoren r = 0,001, r = 0,01, r = 0,035, r = 0,01, r= 0,2 und r = 0,5,

Figur 4 im Vergleich zur Figur 3 die Wellenlängenabhängigkeit des Eingangsreflexionsfaktors des Resonators mit Strahlungsübertragungsstrecke nach Figur 3 in der entsprechenden Umgebung der Resonanz für zwei verschiedene Reflexionsfaktoren $r = 2.10^4$ und $R = 2.10^{-5}$,

Figur 5 die Wellenlängenabhängigkeit der Phase des Eingangsreflexionsfaktors eines herkömmlichen Resonators ohne externer Strahlungsübertragungsstrecke in der Umgebung der Resonanz für die verschiedenen Reflexionsfaktoren,

Figur 6 im Vergleich zur Figur 5 die Wellenlängenabhängigkeit der Phase des Eingangsreflexionsfaktors des Resonators mit externer Strahlungsübertragungsstrecke nach Figur 4 in der entsprechenden Umgebung der Resonanz für die zwei Reflexionsfaktoren,

Figur 7 die Wellenlängenabhängigkeit des Betrags des Eingangsreflexionsfaktors eines Resonators nach Figur 2 mit einem Reflexionsfaktor $r = 2.10^{-4}$ in der Umgebung der Resonanz, bei dem Nachbarmoden zum zentralen Mode teilweise unterdrückt sind,

Figur 8 die Wellenlängenabhängigkeit des Betrags des Einfangsreflexionsfaktors des Resonators nach Figur 1 mit einem wellenlängenselektiven Richtkoppler in der Umgebung der Resonanz, bei dem die Bandbreite etwa gleich dem Modenabstand, d.h. dem freien Spektralbereich des Resonators gewählt ist,

Figur 9 die Wellenlängenabhängigkeit des Betrags des Eingangsreflexionsfaktors des Resonators nach Figur 1 mit einem wellenlängenselektiven Richtkoppler, bei dem die Bandbreite etwa gleich dem dreifachen des Modenabstandes des Resonators gewählt ist,

Figur 10 Resonanzspektren des Betrags des Eingangsreflexionsfaktors des Resonators nach Figur 1 für verschiedene Reflexionsfaktoren, und

Figuren 11 bis 15 verschiedene Ausführungsformen der Rückkopplungseinrichtung RE in Figur 1, die auch für die anderen Rückkopplungseinrichtungen verwendbar sind.

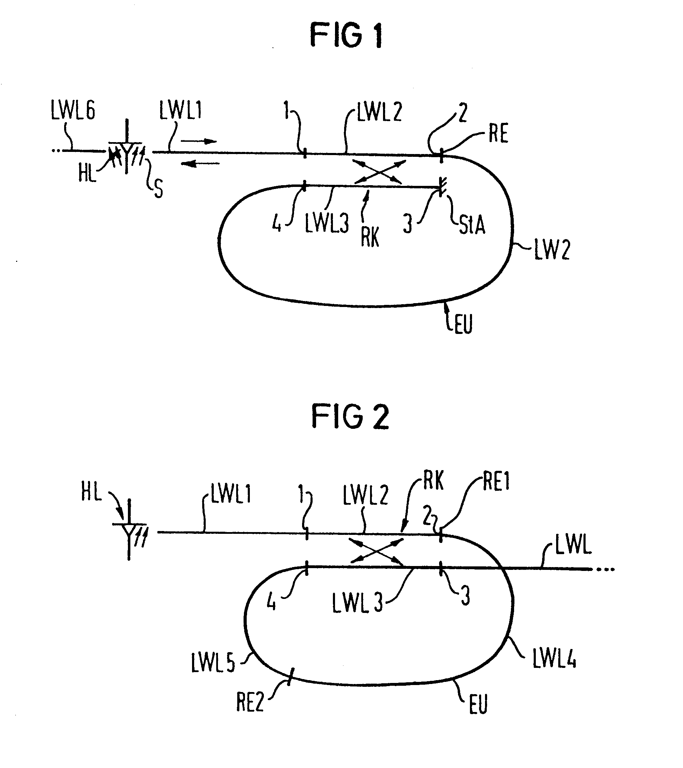

Nach Figur 1 wird die von dem Halbleiterlaser HL, beispielsweise eine Laserdiode, nach rechts ausgesandte Strahlung S in einen Lichtwellenleiter LWL1 eingekoppelt, der die Strahlung dem optischen Richtkoppler RK zuleitet. Ein an den Halbleiterlaser HL anzukoppelnder Lichtwellenleiter LWL6 ist auf der vom Richtkoppler RK abgekehrten linken Seite des Halbleiterlaser HL zum Strahlungsempfang angekoppelt.

Der Richtkoppler RK besteht aus zwei eng benachbarten parallelen Lichtwellenleitern LWL2 und LWL3 bestimmter Länge, zwischen denen die eingekoppelte Strahlung überkoppelt. Der Kopplungsgrad oder -faktor wird nicht zuletzt durch die gemeinsame Länge der beiden Lichtwellenleiter LWL2 und LWL3 bestimmt, deren Enden vier Tore 1 bis 4 des Kopplers definieren. Der Koppelfaktor des Richtkopplers RK ist beispielsweise so gewählt, daß von einer durch ein beliebig ausgewähltes erstes Tor des Kopplers RK, beispielsweise das Tor 1 am einen Ende des Lichtwellenleiters LWL2, eingekoppelten Strahlungsleistung nur zwischen 0 und 5 % auf das Tor 2 am anderen Ende des Lichtwellenleiters LWL2, dagegen zwischen 95 %
und 100 % auf das Tor 3 am anderen Ende des Lichtwellenleiters LWL3 überkoppeln. Analoges gilt dann für jedes
beliebige andere Tor. So koppeln beispielsweise von
einer durch das vierte Tor 4 am einen Ende des Lichtwellenleiters LWL3 eingekoppelten Strahlungsleistung nur
zwischen 0 und 5 % auf das dritte Tor 3 am anderen Ende
dieses Lichtwellenleiters, dagegen zwischen 95 und 100 %
auf das zweite Tor 2 am anderen Ende des Lichtwellenleiters LWL2 über.

Beim Resonator nach Figur 1, bei dem die Strahlung S
durch das erste Tor 1 eingekoppelt wird, können die
Lichtwellenleiter LWL1 und LWL2 aus einem Stück bestehen.

Die die beiden Tore 2 und 4 miteinander verbindende
Strahlungsübertragungsstrecke EU zum kopplerexternen
Übertragen von Strahlungsleistung zwischen dem zweiten
und vierten Tor besteht bei der Ausführungsform nach
Figur 1 aus dem Lichtwellenleiter LWL, der mit seinen
beiden Enden an die Tore 2 und 4 angekoppelt ist.

Zwischen dem Tor 2 und dem diesem gegenüberliegenden
Ende des Lichtwellenleiters LWL ist die Rückkopplungseinrichtung RE angeordnet, die den bestimmten Anteil der
aus dem Tor 2 ausgekoppelten und über den Lichtwellenleiter LWL auf das vierte Tor 4 übertragenen Strahlungsleistung in das zweite Tor 2 und damit in den Lichtwellenleiter LWL 2 zurückkoppelt.

Die Rückkopplungseinrichtung RE kann in jeder der oben
angegebenen Realisierungsmöglichkeiten ausgebildet sein.
In der Figur 1 ist sie symbolisch und stellvertretend
für die übrigen Möglichkeiten durch ein Glasplättchen
realisiert, das einen bestimmten Reflexionsfaktor r
definiert.

Die aus dem dritten Tor 3 ausgekoppelte Strahlung wird von einem Strahlungsabsorber StA nahezu vollständig absorbiert, so daß am dritten Tor 3 eine nahezu rückwirkungsfreie Auskopplung erfolgt. Je rückwirkungsfreier die Auskopplung dort erfolgt, desto besser ist es.

Die Lichtwellenleiter LWL1, LWL2, LWL3 und LWL können aus Glasfasern bestehen. Sie können aber auch ganz oder zum Teil integrierte Lichtwellenleiter sein. Insbesondere kann der Lichtwellenleiter LWL aus einem in eine Glasplatte integrierten Lichtwellenleiter bestehen, der durch ein Ionenaustauschverfahren hergestellt worden ist.

Die Ausführungsform nach Figur 2 unterscheidet sich von der Ausführungsform nach Figur 1 zum einen dadurch, daß in der Strahlungsübertragungsstrecke EU zwei Rückkopplungseinrichtungen RE1 und RE2 mit Abstand voneinander angeordnet sind, zum anderen dadurch, daß der an den Halbleiterlaser HL anzukoppelnde Lichtwellenleiter LWL6 an das dritte Tor 3 des Richtkopplers RK angekoppelt ist und ein Strahlungsabsorber fehlt. Auch bei der Ausführungsform nach Figur 1 könnte diese vorteilhafte Art der Ankopplung gewählt werden. Die Wellenleiter LWL3 und LWL6 können aus einem Stück sein.

Die Rückkopplungseinrichtungen sind so ausgebildet, daß sie beide den gleichen Anteil der zugeführten Strahlung zurückleiten, beispielsweise den gleichen Reflexionsfaktor haben. In diesem Fall können sie auf sehr einfache Weise dadurch realisiert sein, daß die externe Strahlungsübertragungsstrecke EU aus zwei Lichtwellenleitern LWL4 und LWL5 zusammengesetzt ist, die verschiedene Brechzahlen haben. Dabei bestehen zweckmäßigerweise die Lichtwellenleiter LWL, LWL2, LWL3 und LWL5 aus Lichtwellenleitern der gleichen Brechzahl und der Lichtwellenleiter LWL4 aus einem Lichtwellenleiter einer anderen Brechzahl, wobei die beiden Rückkopplungseinheiten RE1 und RE2 einfach durch den Brechzahlsprung an den endflächengekoppelten Lichtwellenleitern LWL2 und LWL4 bzw. LWL4 und LWL5 realisiert sind. Die Lichtwellenleiter LWL4 und LWL5 können Glasfasern oder integrierte Lichtwellenleiter sein.

Bei der Ausführungsform nach Figur 2 sind die Längen der Lichtwellenleiter LWL4 und LWL5 speziell so gewählt, daß der Lichtwellenleiter LWL4 drei Viertel und der Lichtwellenleiter LWL5 ein Viertel der gesamten Länge der Strahlungsübertragungsstrecke einnimmt.

Die Strahlungsübertragungsstrecke EU gibt dem hier beschriebenen Resonator ein ringförmiges Aussehen, so daß er auch als Ringresonator bezeichnet werden kann.

Es werden nun die Eigenschaften eines Resonators nach Figur 1 oder 2 anhand der Wellenlängenabhängigkeit des Betrags und der Phase des Eingangsreflexionsfaktors $S_{11}$ in der Umgebung der Resonanz näher erläutert, insbesondere im Vergleich zu einem herkömmlichen Resonator.

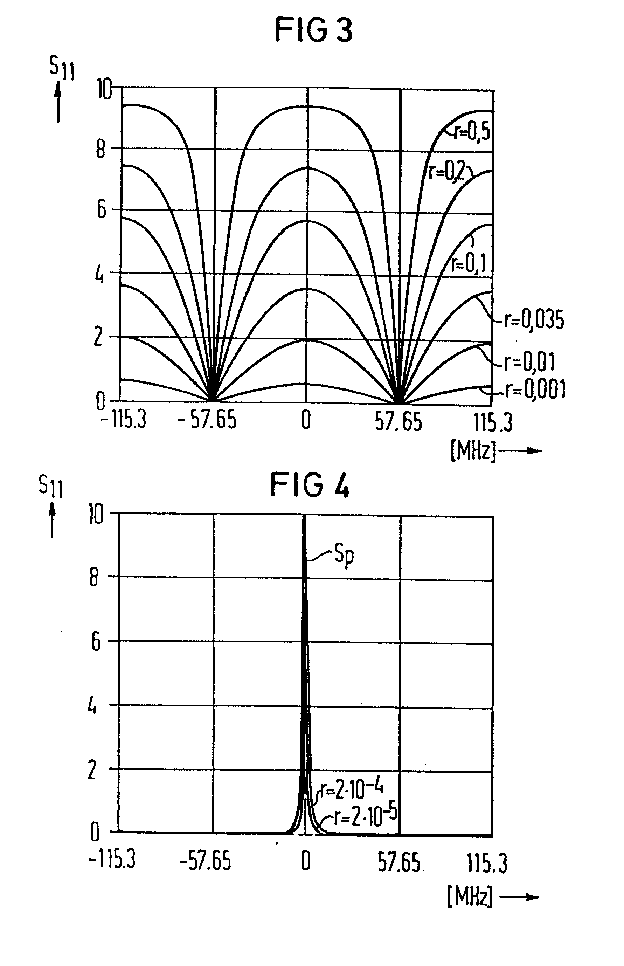

Dazu dienen die Kurvendiagramme der Figuren 3 bis 10, in denen der Eingangsreflexionsfaktor oder die Phase in Abhängigkeit von der Wellenlänge aufgetragen ist und bei denen der Nullpunkt in die Wellenlänge der Resonanz gelegt ist.

Die Figur 3 zeigt deutlich eine relativ schwache spektrale Selektivität des herkömmlichen Resonators.

Im Vergleich dazu hat der Resonator nach Figur 1 die in Figur 4 gezeigte viel höhere spektrale Selektivität, die sich in der bei der Resonanzwellenlänge befindlichen zentralen Spitze bzw. dem zentralen Mode Sp zeigt.

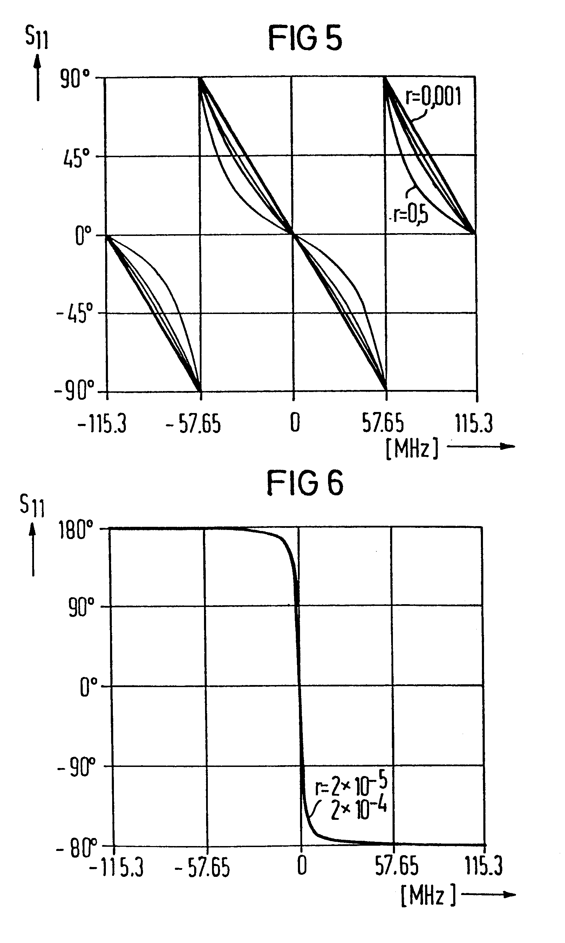

Der Vergleich der Figur 5 mit der Figur 6 zeigt deutlich, daß der Resonator nach Figur 1 in der Umgebung der Resonanz eine erheblich höhere Phasensteilheit aufweist, als der der Figur 3 zugrundeliegende Resonator ohne Strahlungsübertragungsstrecke. Außerdem fallen nach Figur 6 die Phasenkurven für beiden Reflexionsfaktoren $r = 2.10^{-4}$ und $r = 2.10^{-5}$ praktisch zusammen.

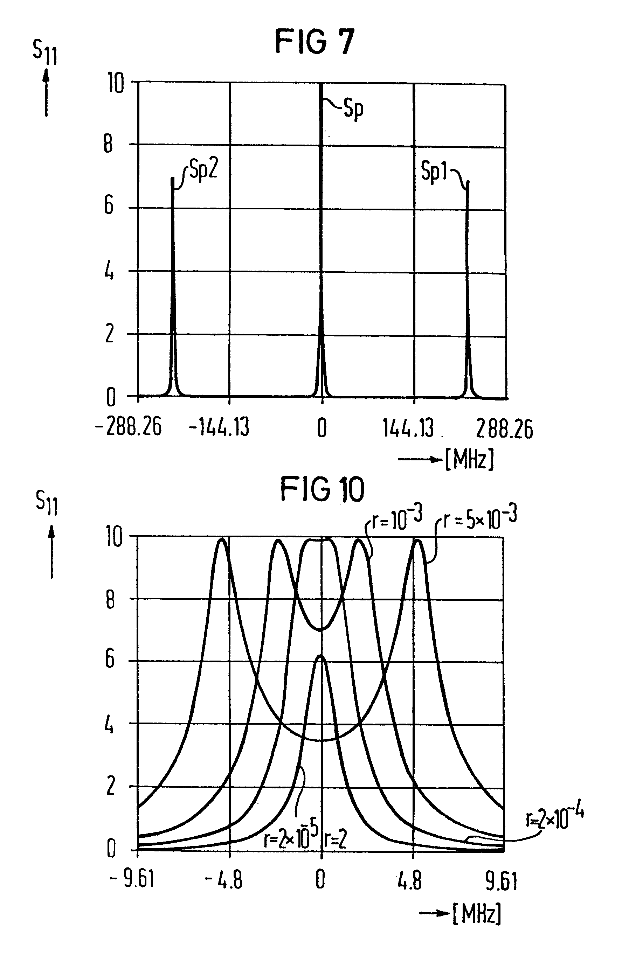

Nachbar- oder Nebenmoden zum zentralen Mode bei der Resonanzwellenlänge lassen sich mit dem Resonator nach Figur 2 teilweise unterdrücken, wie dies die Figur 7 zeigt, nach der die den beiden Nachbarmoden entsprechenden und links und rechts von dem bei der Resonanzwellenlänge befindlichen zentralen Mode Sp liegenden Spitzen Sp1 und Sp2 deutlich niedriger sind als der zentrale Mode.

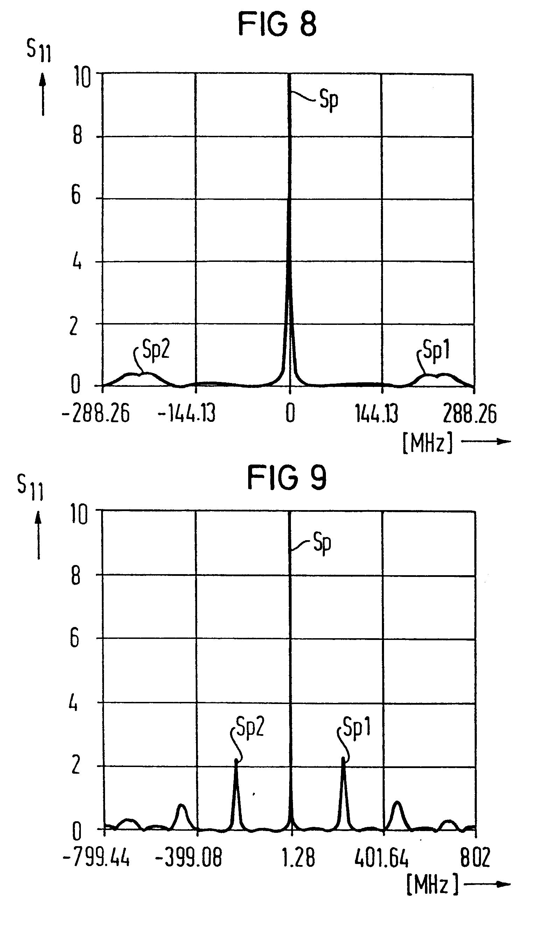

Eine nahezu vollständige Unterdrückung aller Nebenmoden kann bei einem Resonator nach Figur 1 oder 2 durch Verwendung eines wellenlängenselektiven Richtkopplers anstelle eines breitbandigen Richtkopplers erzielt werden. Die Figur 8 zeigt dies für einen derartigen Resonators, bei dem die Bandbreite des Koppelfaktors des wellenlängenselektiven Richtkopplers bei der Resonanzwellenlänge des Resonators etwa gleich dessen freiem Spektralbereich gewählt ist, d.h. gleich dem Abstand zwischen dem zentralen Mode Sp und einem Nachbarmode. Danach sind die Nachbarmoden Sp1 und Sp2, die in der Figur 7 noch deutlich als ausgeprägte Spitzen auftreten, nahezu ganz unterdrückt.

Allerdings erhält man beispielsweise auch bei der dreifachen Bandbreite des wellenlängenselektiven Kopplers noch eine relativ starke Unterdrückung der Nebenmoden, wie dies aus der Figur 9 zu entnehmen ist. Auch in diesem Fall bleibt die Selektivität des zentralen Modes unverändert.

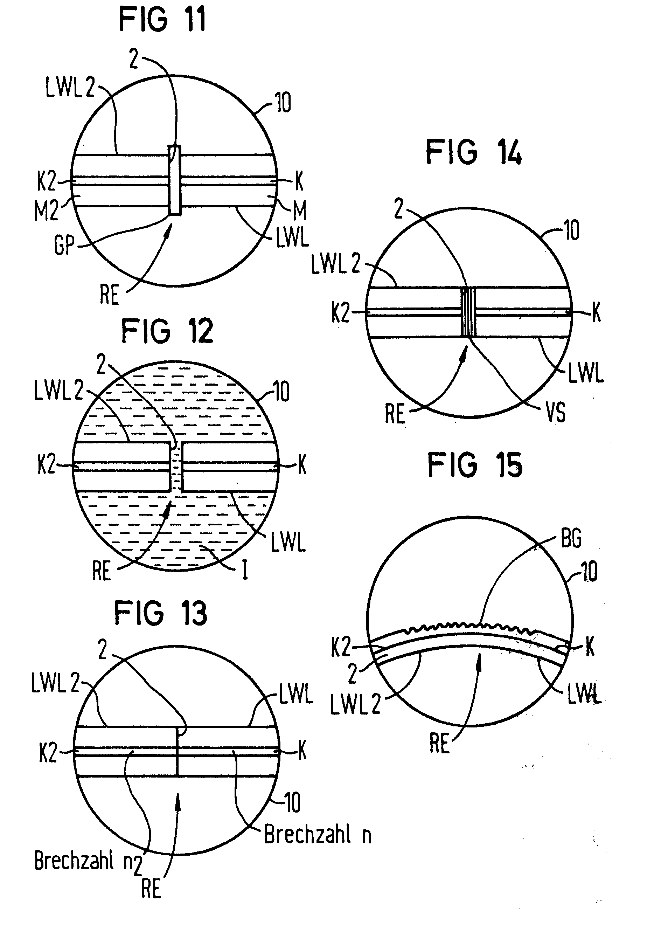

Die Figur 10 zeigt den Einfluß des Reflexionsfaktors r auf die Kurvenform des Eingangsreflexionsfaktors $S_{11}$ des Resonators als Funktion der Wellenlänge. Es sind die Kurvenformen für die Reflexionsfaktoren $r = 2.10^{-5}$, $r = 2.10^{-4}$, $r = 10^{-3}$ und $r = 5.10^{-3}$ gezeigt. Danach können mit dem hier vorgeschlagenen Resonator Kurvenformen von stark unterkritisch bis stark überkritisch realisiert werden.

Die Figuren 11 bis 15 zeigen den Kreisausschnitt 10 mit der Rückkopplungseinrichtung RE in vergrößerter Darstellung für verschiedene Ausführungsformen dieser Einrichtung. Die optischen Lichtwellenleiter LWL2 und LWL sind Kern-Mantel-Glasfasern mit den Kernen $K_2$ bzw. K und den umgebenden Manteln $M_2$ bzw. M. Die Wellenleiter LWL2 und LWL könnten auch beispielsweise integrierte Streifenwellenleiter sein, wobei dann $K_2$ bzw. K Streifenwellenleiter wären, die auf einem Substrat $M_2$ bzw. M integriert sind.

Bei der Ausführungsform nach Figur 11 ist die Rückkopplungseinrichtung ein durch einen Brechzahlsprung realisierter teildurchlässiger Reflektor, der durch ein zwischen den Wellenleitern LWL2 und LWL angeordnetes und einige zehn bis hundert Wellenlängen dickes Glasplätchen GP definiert ist.

Bei den Ausführungsformen nach den Figuren 12 und 13 ist der Brechzahlsprung durch eine Immersionsflüssigkeit I zwischen den Wellenleitern LWL2 bzw. LWL bzw. durch Endflächenkopplung der beiden Wellenleiter LWL2 bzw. LWL unterschiedlicher Brechzahlen $n_2$ bzw. n.

Bei der Ausführungsform nach Figur 14 ist der Brechzahlsprung durch aufgedampfte Schichten VS definiert, beispielsweise durch eine dielektrische Vielfachschicht, die auch frequenzselektiv wirken kann.

Bei der Ausführungsform nach Figur 15 ist die frequenzselektive Rückkopplungseinrichtung durch eine Beugungsgitterstruktur BG auf dem Wellenleiter LWL definiert.

Die dargestellten Ausführungsformen sind auch für die
Rückkopplungseinrichtungen RE1 und RE2 geeignet.


26 Patentansprüche
15 Figuren

Patentansprüche

1. Externer optischer Resonator für einen Halbleiterlaser (HL),

g e k e n n z e i c h n e t   d u r c h

1.1. einen optischen Viertor-Koppler (RK), wobei

1.1.1 durch ein an den Halbleiterlaser (HL) ankoppelbares erstes Tor (1 oder 4) des Kopplers
(RK) eingekoppelte Strahlungsleistung aus dem
vom Halbleiterlaser (HL) abgestrahlten Spektralbereich nur geringfügig auf ein zweites Tor (2
bzw. 3) des Kopplers (RK) und nahezu vollständig
auf ein drittes Tor (3 bzw. 2) überkoppelt, wobei

1.1.2 durch ein viertes Tor (4 bzw. 1) des Kopplers
(RK) eingekoppelte Strahlungsleistung aus dem
genannten Spektralbereich nahezu vollständig auf
das zweite Tor (2 bzw. 3) und nur geringfügig
auf das dritte Tor (3 bzw. 2) überkoppelt,
und wobei

1.1.3 durch das zweite Tor (2 bzw. 3) eingekoppelte
Strahlungsleistung aus dem genannten Spektralbereich auf das erste Tor (1 bzw. 4) überkoppelt,
durch

1.2. eine zwischen das zweite Tor (2 bzw. 3) und das
vierte Tor (3 bzw. 2) geschaltete und einen optischen Wellenleiter (LWL; LWL4, LWL5) aufweisende
Strahlungsübertragungsstrecke (EU) zum kopplerexternen Übertragen von Strahlungsleistung zwischen
dem zweiten und vierten Tor,
und durch

1.3 eine Rückkopplungseinrichtung (RE; RE1, RE2) zum
Rückkoppeln eines bestimmten Anteils der aus dem
zweiten Tor (2 bzw. 3) ausgekoppelten und auf der
Strahlungsübertragungsstrecke (EU) übertragenen
Strahlungsleistung zurück in dieses zweite Tor (2
bzw. 3).

2. Resonator nach Anspruch 1, d a d u r c h   g e -
k e n n z e i c h n e t ,   daß der Koppler (RK) zwischen 95 % und 100 % der durch das erste Tor (1 bzw. 4)
eingekoppelten Strahlungsleistung aus dem genannten
Spektralbereich auf das dritte Tor (3 bzw. 2) überkoppelt.

3. Resonator nach Anspruch 1 oder 2, insbesondere nach
Anspruch 2, d a d u r c h   g e k e n n z e i c h n e t ,
daß der Koppler (RK) zwischen 95 % und 100 % der durch
das vierte Tor (4 bzw. 1) eingekoppelten Strahlungsleistung auf das zweite Tor (2 bzw. 3) überkoppelt.

4. Resonator nach einem der vorhergehenden Ansprüche,
d a d u r c h   g e k e n n z e i c h n e t ,   daß der
Koppler (RK) ein breitbandiger Koppler ist.

5. Resonator nach einem der Ansprüche 1 bis 3, d a -
d u r c h   g e k e n n z e i c h n e t ,   daß der
Koppler (RK) ein wellenlängenselektiver Koppler ist.

6. Resonator nach einem der vorhergehenden Ansprüche,
d a d u r c h   g e k e n n z e i c h n e t ,   daß auf
das dritte Tor (3 bzw. 2) überkoppelnde Strahlungsleistung rückwirkungsfrei aus diesem Tor auskoppelt.

7. Resonator nach einem der vorhergehenden Ansprüche,
d a d u r c h   g e k e n n z e i c h n e t ,   daß ein
an den Halbleiterlaser (HL) anzukoppelnder optischer
Wellenleiter (LWL6) über das dritte Tor (3 bzw. 2) des
Kopplers (RK) an den Halbleiterlaser (HL) angekoppelt
ist.

8. Resonator nach Anspruch 6, d a d u r c h   g e -
k e n n z e i c h n e t ,   daß die rückwirkungsfreie
Auskopplung aus dem dritten Tor (3 bzw. 2) durch einen
Strahlungsabsorber (StA) bewirkt ist, der die ausgekoppelte Strahlungsleistung absorbiert.

9. Resonator nach einem der vorhergehenden Ansprüche, d a d u r c h   g e k e n n z e i c h n e t , daß der Koppler (RK) aus einem optischen Richtkoppler besteht.

10. Resonator nach Anspruch 9, d a d u r c h   g e k e n n z e i c h n e t , daß der Richtkoppler aus einem Glasfaserrichtkoppler besteht.

11. Resonator nach Anspruch 9, d a d u r c h   g e k e n n z e i c h n e t , daß der Richtkoppler ein integrierter Koppler ist.

12. Resonator nach einem der vorhergehenden Ansprüche, insbesondere nach Anspruch 10, d a d u r c h   g e k e n n z e i c h n e t , daß der optische Wellenleiter (LWL; LWL4, LWL5) der Strahlungsübertragungsstrecke (EU) aus einer Glasfaser besteht.

13. Resonator nach einem der Ansprüche 1 bis 11, insbesondere nach Anspruch 11, d a d u r c h   g e k e n n z e i c h n e t , daß der optische Wellenleiter (LWL; LWL4, LWL5) aus einem integrierten Wellenleiter besteht.

14. Resonator nach Anspruch 13, d a d u r c h   g e k e n n z e i c h n e t , daß der integrierte Wellenleiter ein in einem Glaskörper durch ein Ionenaustauschverfahren erzeugter Wellenleiter ist.

15. Resonator nach einem der vorhergehenden Ansprüche, d a d u r c h   g e k e n n z e i c h n e t , daß die Rückkopplungseinrichtung (RE; RE1, RE2) aus einem teildurchlässigen Reflektor besteht.

16. Resonator nach Anspruch 15, d a d u r c h   g e k e n n z e i c h n e t , daß der teildurchlässige Reflektor durch einen Brechzahlsprung realisiert ist.

17. Resonator nach Anspruch 16, d a d u r c h   g e -
k e n n z e i c h n e t , daß der Brechzahlsprung durch
ein einige zehn bis hundert Wellenlängen dickes Glasplättchen (GP) realisiert ist.

18. Resonator nach Anspruch 16, d a d u r c h   g e -
k e n n z e i c h n e t , daß der Brechzahlsprung durch
eine Immersionsflüssigkeit (I) realisiert ist.

19. Resonator nach Anspruch 16, d a d u r c h   g e -
k e n n z e i c h n e t , daß der Brechzahlsprung durch
eine Endflächenkopplung zweier optischer Wellenleiter
unterschiedlicher Brechzahl realisiert ist.

20. Resonator nach Anspruch 15, d a d u r c h   g e -
k e n n z e i c h n e t , daß der teildurchlässige
Reflektor durch aufgedampfte Schichten (VS) realisiert
ist.

21. Resonator nach einem der Ansprüche 1 bis 14, g e -
k e n n z e i c h n e t   d u r c h eine frequenzselektiv wirkende Rückkopplungseinrichtung (RE; RE1,
RE2).

22. Resonator nach Anspruch 21, d a d u r c h   g e -
k e n n z e i c h n e t , daß die Rückkopplungseinrichtung (RE; RE1, RE2) durch eine auf einem optischen Wellenleiter ausgebildete Beugungsgitterstruktur (BG) gebildet ist.

23. Resonator nach einem der vorhergehenden Ansprüche,
d a d u r c h   g e k e n n z e i c h n e t , daß die
Rückkopplungseinrichtung (RE; RE1) zwischen dem zweiten
Tor (2 bzw. 3) oder dem vierten Tor (4 bzw. 1) des
Kopplers (RK) und dem daran angekoppelten optischen
Wellenleiter (LWL; LWL4 bzw. LWL5) angeordnet ist.

24. Resonator nach einem der vorhergehenden Ansprüche, d a d u r c h   g e k e n n z e i c h n e t , daß zwei oder mehrere Rückkopplungseinrichtungen (RE1, RE2) in der Strahlungsübertragungsstrecke (EU) angeordnet sind.

25. Resonator nach Anspruch 24, d a d u r c h   g e - k e n n z e i c h n e t , daß eine Rückkopplungseinrichtung (RE2) mit Abstand von dem zweiten Tor (2 bzw. 3) und dem vierten Tor (4 bzw. 1) des Kopplers (RK) angeordnet ist.

26. Resonator nach Anspruch 23, 24 und 25, d a d u r c h   g e k e n n z e i c h n e t , daß die mit Abstand von dem zweiten und vierten Tor angeordnete Rückkopplungseinrichtung (RE2) im Abstand von drei Viertel der gesamten Länge der Strahlungsübertragungsstrecke (EU) von dem zweiten Tor (2 bzw. 3) angeordnet ist, wo sich auch die eine Rückkopplungseinrichtung (RE1) befindet.

0216212
86 P 1 0 0 6 E

**Bezugszeichenliste**

| | |
|---|---|
| HL | Halbleiterlaser |
| S | Strahlung |
| LWL1 | Lichtwellenleiter - leitet Strahlung S dem Richtkoppler RK zu |
| RK | Richtkoppler |
| LWL6 | Lichtwellenleiter - an Halbleiterlaser HL anzukoppeln |
| LWL2 | Lichtwellenleiter |
| LWL3 | Lichtwellenleiter - benachbart und parallel zum Lichtwellenleiter LWL2 |
| 1 | erstes Tor - am einen Ende des Lichtwellenleiters LWL2 |
| 2 | zweites Tor - am anderen Ende des Lichtwellenleiters LWL2 |
| 3 | drittes Tor - am anderen Ende des Lichtwellenleiters LWL3 |
| 4 | viertes Tor - am einen Ende des Lichtwellenleiters LWL3 |
| EU | Strahlungsübertragungsstrecke - zum kopplerexternen Übertragen von Strahlung zwischen dem zweiten und vierten Tor 2 bzw. 4 |
| LWL | Lichtwellenleiter - bildet Strahlungsübertragungsstrecke EU |
| RE | Rückkopplungseinrichtung |
| StA | Strahlungsabsorber |
| RE1 | Rückkopplungseinrichtung |
| RE2 | Rückkopplungseinrichtung - mit Abstand von Rückkopplungseinrichtung RE1 angeordnet |
| LWL4 | Lichtwellenleiter - bildet Strahlungsübertragungsstrecke EU |
| LWL5 | Lichtwellenleiter - bildet zusammen mit LWL4 Strahlungsübertragungsstrecke EU |
| $S_{11}$ | Eingangsreflexionsfaktor |
| Sp | zentraler Mode |

0216212
86 P 1 0 0 6 E

| | |
|---|---|
| Sp1 | Spitze eines Nachbarmodes |
| Sp2 | Spitze eines Nachbarmodes |
| 10 | Kreisausschnitt |
| $K_2$ | Kern des Lichtwellenleiters LWL2 |
| K | Kern des Lichtwellenleiters LWL |
| $M_2$ | Mantel des Lichtwellenleiters LWL2 |
| M | Mantel des Lichtwellenleiters LWL |
| GP | Glasplättchen |
| I | Immersionsflüssigkeit |
| $n_2$ | Brechzahl von LWL2 |
| n | Brechzahl von LWL1 |
| VS | aufgedampfte Schichten |
| BG | Beugungsgitterstruktur auf LWL |

## FIG 1

## FIG 2

0216212

## FIG 3

## FIG 4

## FIG 5

## FIG 6

## FIG 7

## FIG 10

FIG 8

FIG 9

0216212

## FIG 11

## FIG 14

## FIG 12

## FIG 15

## FIG 13